# EUROPEAN PATENT APPLICATION

(11) **EP 4 545 269 A1**
(43) Date of publication of application: **30.04.2025**
(21) Application number: 23830713.6
(22) Date of filing: 15.02.2023
(51) Int. Cl.: B29C 45/02, B29C 45/42, H01L 21/56

(54) **RESIN MOLDING APPARATUS AND METHOD FOR PRODUCING RESIN MOLDED ARTICLE**

(30) Priority: 27.06.2022 JP 2022102379
(71) Applicant: Towa Corporation, Kyoto-shi, Kyoto 601-8105 (JP)
(72) Inventor: TAKADA, Junko, Kyoto-shi Kyoto 601-8105 (JP); TAKADA, Naoki, Kyoto-shi Kyoto 601-8105 (JP); IKENISHI, Tetsuro, Kyoto-shi Kyoto 601-8105 (JP)
(74) Representative: Becker, Eberhard
(86) International application number: PCT/JP2023/005313
(87) International publication number: WO 2024/004257

(57) **Abstract**

Provided is a resin molding apparatus capable of taking out an object to be molded that has been stored in a conveyance member to perform resin molding. The resin molding apparatus comprises: a take-out mechanism that takes out an object to be molded from a conveyance member in which the object to be molded has been stored; a first object to be molded conveyance mechanism that conveys the object to be molded that has been taken out from the conveyance member to a mold; a conveyance member storage part capable of storing the conveyance member from which the object to be molded has been taken out; a conveyance member conveyance mechanism that conveys the conveyance member from which the object to be molded has been taken out to the conveyance member storage part; a mold clamping mechanism that clamps the mold to which the object to be molded has been conveyed to perform resin molding; a second object to be molded conveyance mechanism that conveys the molded object to be molded from the mold; and an object to be molded storage mechanism that stores the object to be molded conveyed from the mold in the conveyance member stored in the conveyance member storage part.

## Description

### Technical Field

The present invention relates to technologies of a resin molding apparatus and a method for producing a resin molded product.

### Related Art

Generally, a technology is known in which a plurality of molding objects such as circuit boards are accommodated in a conveyance member and conveyed together. Patent Document 1 discloses a technology in which a plurality of circuit boards are subjected to a molding process while being accommodated in a conveyance member called a boat.

### Prior-Art Documents

### Patent Documents

Patent Document 1: Korean Patent Laid-open No. 10-2016-0081289

### SUMMARY OF THE INVENTION

### Problems to Be Solved by the Invention

In the technology described in Patent Document 1, in the molding process, the conveyance member accommodating the plurality of molding objects is fed to a molding die for resin molding. Accordingly, since it is necessary for the molding die to accommodate the conveyance member, there is a risk that the molding die may be increased in size. In the technology described in Patent Document 1, positioning of the molding object with respect to the molding die is indirectly performed by positioning the conveyance member with respect to the molding die. Hence, there is a risk that positional accuracy of the molding object with respect to the molding die may be reduced. Accordingly, there is a demand for a technology in which a molding object accommodated in a conveyance member can be taken out for resin molding, followed by being accommodated again in the conveyance member.

The present invention has been made in view of the above circumstances, and a problem to be solved by the present invention is to provide a resin molding apparatus and a method for producing a resin molded product, in which a molding object accommodated in a conveyance member can be taken out for resin molding, followed by being accommodated again in the conveyance member.

### Means for Solving the Problems

The problem to be solved by the present invention is as described above. In order to solve this problem, a resin molding apparatus according to the present invention includes: a take-out mechanism, taking out a molding object from a conveyance member accommodating the molding object; a first molding object conveyance mechanism, conveying the molding object taken out from the conveyance member to a molding die; a conveyance member accommodation part, capable of accommodating the conveyance member from which the molding object has been taken out; a conveyance member conveyance mechanism, conveying, to the conveyance member accommodation part, the conveyance member from which the molding object has been taken out; a mold clamping mechanism, clamping the molding die to which the molding object is conveyed, so as to perform resin molding; a second molding object conveyance mechanism, carrying the molding object after molding out of the molding die; and a molding object accommodation mechanism, causing the conveyance member accommodated in the conveyance member accommodation part to accommodate the molding object carried out of the molding die.

A method for producing a resin molded product according to the present invention is a method for producing a resin molded product using the aforementioned resin molding apparatus. The method includes: taking out the molding object from the conveyance member; conveying the molding object taken out in the taking out the molding object to the molding die; conveying the conveyance member from which the molding object has been taken out; resin molding the molding object conveyed to the molding die in the conveying the molding object; and accommodating the molding object resin molded in the resin molding the molding object in the conveyance member conveyed in the conveying the conveyance member.

### Effects of the Invention

According to the present invention, the molding object accommodated in the conveyance member can be taken out for resin molding, followed by being accommodated again in the conveyance member.

### BRIEF DESCRIPTION OF THE DRAWINGS

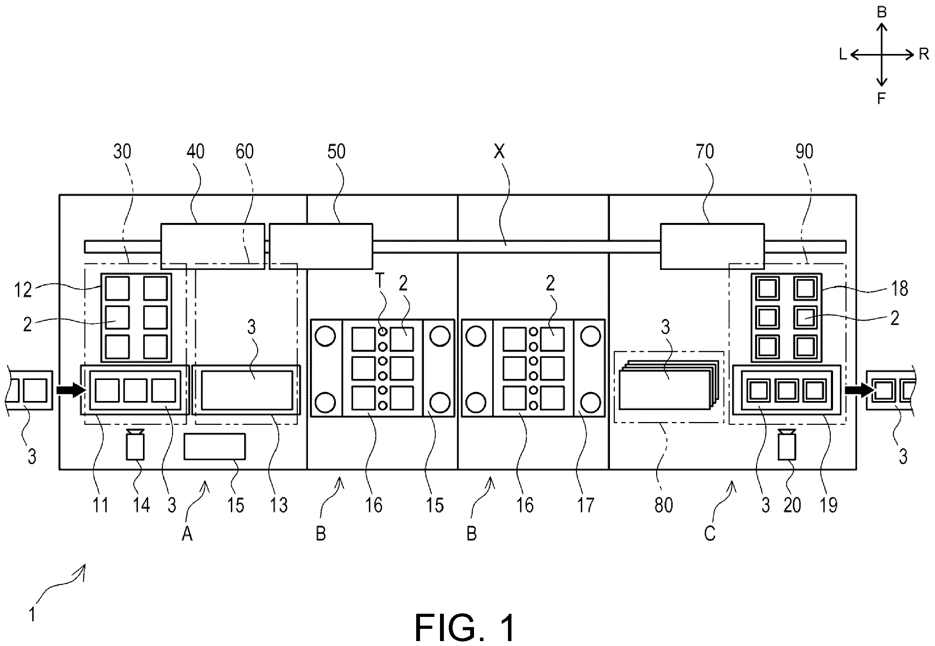

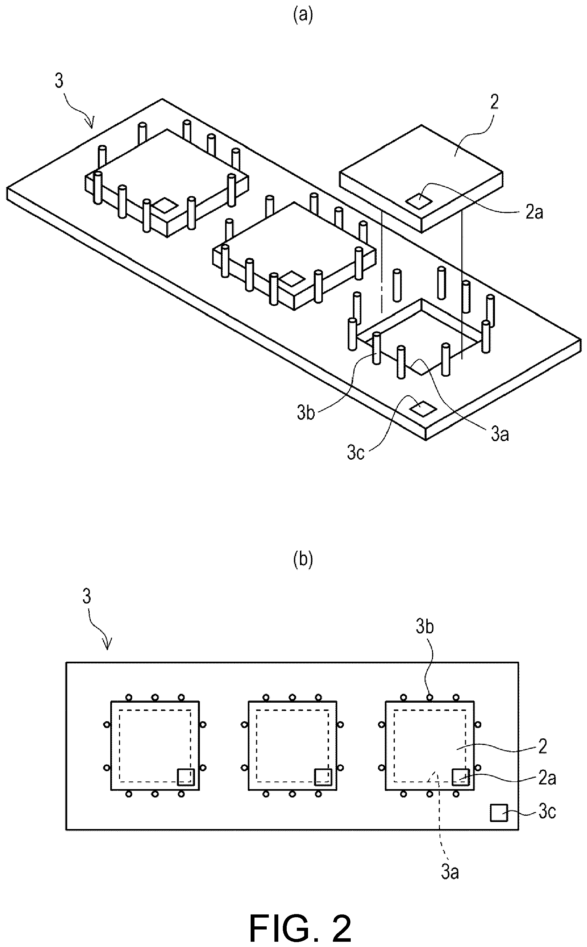

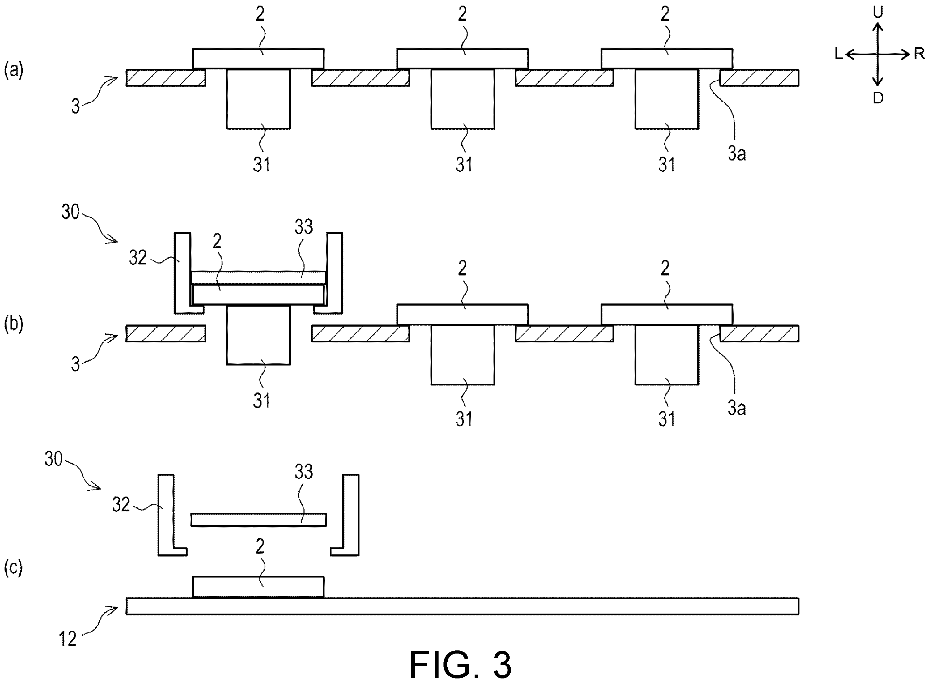

FIG. 1 is a plan view illustrating an overall configuration of a resin molding apparatus according to an embodiment.
(a) of FIG. 2 is a perspective view illustrating a carrier and a substrate. (b) of FIG. 2 is a plan view illustrating the carrier and the substrate.
(a) of FIG. 3 is a partial cross-sectional front view illustrating a manner in which the substrate is suctioned and held by a take-out mechanism. (b) of FIG. 3 is a partial cross-sectional front view illustrating a manner in which the substrate is held by a clamper of the take-out mechanism. (c) of FIG. 3 is a front view illustrating a manner in which the substrate is placed on a substrate alignment stage.
FIG. 4 is a side view illustrating the substrate alignment stage and a loader.
FIG. 5 is a side view illustrating a carrier conveyance unit and a carrier transfer part.
(a) of FIG. 6 is a side view illustrating a carrier accommodation part. (b) of FIG. 6 is a side view illustrating a manner in which the carrier is lifted up. (c) of FIG. 6 is a side view illustrating a manner in which the carrier is placed on a rotary support.
FIG. 7 is a flowchart illustrating a method for producing a resin molded product.
FIG. 8 is a plan view illustrating a manner of conveyance of the substrate and the carrier until resin molding is performed.
FIG. 9 is a plan view illustrating a manner of conveyance of the substrate and the carrier after resin molding.
(a) of FIG. 10 is a plan view illustrating a manner in which the loader is retreated to a retreat position. (b) of FIG. 10 is a plan view illustrating an arrangement order of substrates on the substrate alignment stage.
FIG. 11 is a side view illustrating a modification of the carrier accommodation part.

### DESCRIPTION OF THE EMBODIMENTS

In the following, the directions indicated by arrow U, arrow D, arrow L, arrow R, arrow F, and arrow B illustrated in the drawings are defined as an upward direction, a downward direction, a leftward direction, a rightward direction, a forward direction, and a backward direction, respectively, for description.

### <Overall Configuration of Resin Molding Apparatus 1>

First, a configuration of a resin molding apparatus 1 according to the present embodiment is described with reference to FIG. 1. The resin molding apparatus 1 seals an electronic element (hereinafter "chip") such as a semiconductor chip with resin, and produces a resin molded product. Particularly, the present embodiment illustrates the resin molding apparatus 1 that performs resin molding by using a transfer mold method.

The resin molding apparatus 1 includes a supply module A, a resin molding module B and a carry-out module C as components. Each component is attachable/detachable and interchangeable with respect to any other component.

### <Supply Module A>

The supply module A supplies, to the resin molding module B, a substrate 2 on which a chip is fixed and a resin tablet T of a columnar shape. The substrate 2 is an embodiment of a molding object according to the present invention. As the substrate 2, various substrates (such as lead frame, glass epoxy substrate, ceramic substrate, resin substrate, and metal substrate) can be used. The supply module A mainly includes: a carrier carry-in part 11, a substrate alignment stage 12, a take-out mechanism 30, a carrier stage 13, a loader 40, a carrier conveyance unit 50, a carrier transfer part 60, a first camera 14, and a control part 15.

The carrier carry-in part 11 is a portion where a carrier 3 carried into the supply module A from the outside is arranged. The carrier carry-in part 11 is able to receive the carrier 3 accommodating the substrate 2 and have the carrier 3 placed on its upper surface.

Here, the substrate 2 and the carrier 3 capable of accommodating the substrate 2 are described with reference to FIG. 2. The carrier 3 is a member capable of accommodating the substrate 2. The carrier 3 is an embodiment of a conveyance member according to the present invention. The carrier 3 is formed in a substantially rectangular plate shape. The carrier 3 is provided with a through hole 3a, a pin 3b, and a code 3c.

The through hole 3a is formed so as to penetrate the carrier 3. The through hole 3a is formed so that three through holes 3a are arranged side by side in a longitudinal direction of the carrier 3. The pin 3b positions the substrate 2 accommodated in the carrier 3. The pin 3b is formed so as to protrude upward from a surface (upper surface) of the carrier 3. A plurality of pins 3b are provided so as to surround a periphery of the through hole 3a. By accommodating the substrate 2 inside the pin 3b, the substrate 2 can be arranged at a position facing the through hole 3a. The carrier 3 of the present embodiment is able to accommodate three substrates 2.

The code 3c is provided on the upper surface of the carrier 3. The code 3c is an identifier representing information that makes it possible to identify the carrier 3. As the code 3c, for example, a barcode or a two-dimensional code, can be used.

A code 2a is provided on an upper surface of the substrate 2. The code 2a is an identifier representing information that makes it possible to identify the substrate 2. As the code 2a, like the code 3c of the carrier 3, a two-dimensional code or the like can be used.

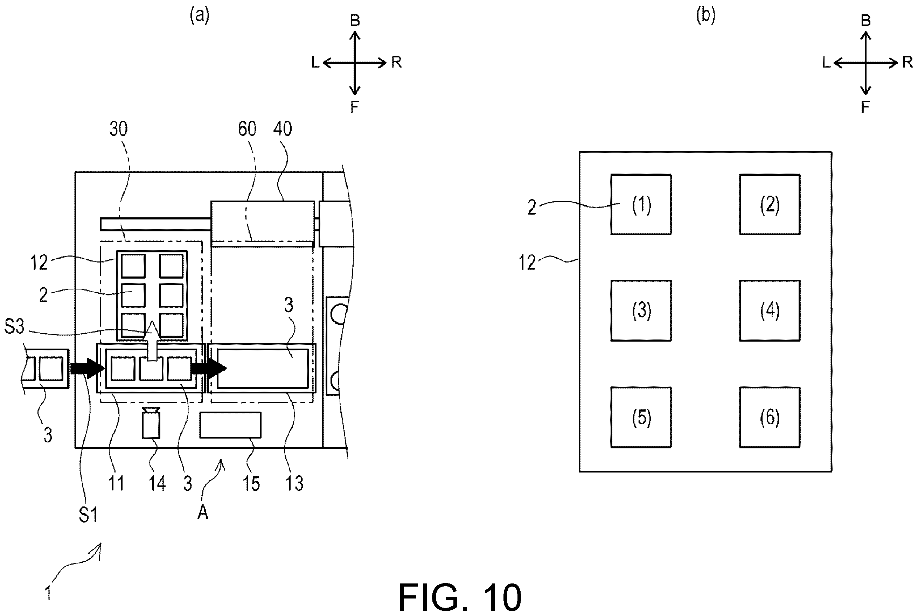

The substrate alignment stage 12 illustrated in FIG. 1 is a portion where the substrate 2 taken out from the carrier 3 is arranged. The substrate alignment stage 12 is an embodiment of a placement part according to the present invention. The substrate alignment stage 12 allows a plurality of substrates 2 to be placed side by side on its upper surface. In the present embodiment, a total of six substrates 2 in three rows in the front-back direction and two rows in the left-right direction (see (b) of FIG. 10) are aligned and placed on the substrate alignment stage 12. The arrangement of the substrate 2 on the substrate alignment stage 12 corresponds to an arrangement of the substrate 2 in a molding die 16 described later. That is, the molding die 16 according to the present embodiment is able to perform resin molding on six substrates 2 at one time. The substrate alignment stage 12 is arranged to the back of the carrier carry-in part 11.

The take-out mechanism 30 takes out the substrate 2 from the carrier 3 of the carrier carry-in part 11 and arranges the substrate 2 on the substrate alignment stage 12. As illustrated in FIG. 3, the take-out mechanism 30 mainly includes a suction holding part 31, a clamper 32 and a pressing part 33.

The suction holding part 31 suctions and holds the substrate 2 placed in the carrier carry-in part 11. The suction holding part 31 is able to suction the substrate 2 from below via the through hole 3a of the carrier 3. The suction holding part 31 can be moved up and down by a lifting mechanism (not illustrated). Accordingly, the suction holding part 31 is able to lift the suctioned substrate 2 upward from the carrier 3.

The clamper 32 holds and conveys the substrate 2. The clamper 32 includes a pair of left and right members and a pair of front and back members having an L shape in a side view. The clamper 32 is able to hold the substrate 2 by clamping the substrate 2 from four directions, namely left and right, front and back. The clamper 32 can be moved by a movement mechanism (not illustrated).

The pressing part 33 presses from above the substrate 2 held by the clamper 32. The pressing part 33 is arranged inside the clamper 32. The pressing part 33 is placed on the substrate 2, thereby being able to press the substrate 2 by its own weight.

In the case of taking out the substrate 2 from the carrier 3 of the carrier carry-in part 11 by the take-out mechanism 30, first, as illustrated in (a) of FIG. 3, the substrate 2 is held by the suction holding part 31. Next, as illustrated in (b) of FIG. 3, the suction holding part 31 holding the substrate 2 as a target rises, and the substrate 2 is lifted up. Next, the suctioning by the suction holding part 31 is canceled, and the substrate 2 is held by the clamper 32. Furthermore, the substrate 2 is pressed from above by the pressing part 33. Accordingly, the substrate 2 can be stably held by the clamper 32.

Next, as illustrated in (c) of FIG. 3, the clamper 32 moves to the substrate alignment stage 12, and cancels holding of the substrate 2 in a predetermined place. Accordingly, the substrate 2 can be placed on the substrate alignment stage 12. By repeating such an operation of the clamper 32, the substrates 2 can be taken out from the carrier 3 of the carrier carry-in part 11 and arranged side by side on the substrate alignment stage 12.

The carrier stage 13 illustrated in FIG. 1 is a portion where the carrier 3 from which the substrate 2 has been taken out is arranged in the carrier carry-in part 11. The carrier stage 13 allows the carrier 3 transferred from the carrier carry-in part 11 to be placed on its upper surface.

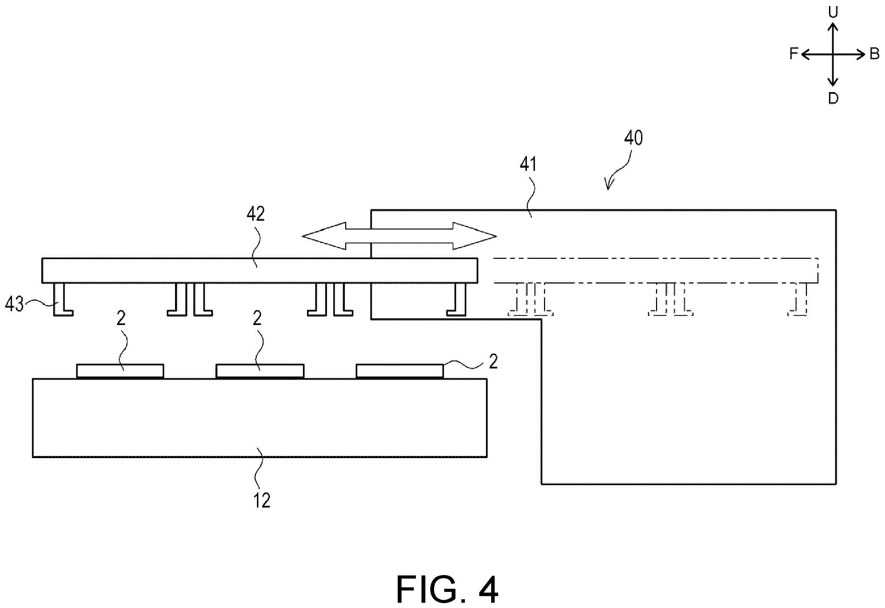

The loader 40 conveys the substrate 2 aligned on the substrate alignment stage 12 to the resin molding module B. The loader 40 receives from a resin supply device (not illustrated) the resin tablet T, holds it, and conveys it together with the substrate 2 to the resin molding module B. Here, the loader 40 may receive either the substrate 2 or the resin tablet T first, or may receive the substrate 2 and the resin tablet T at the same time. That is, a timing at which the loader 40 receives the substrate 2 and the resin tablet T is not particularly limited. The loader 40 is an embodiment of a first molding object conveyance mechanism according to the present invention. The loader 40 is arranged in a back part of the resin molding apparatus 1. The loader 40 is movable left and right along a rail X extending across both the left and right ends of the resin molding apparatus 1. As illustrated in FIG. 4, the loader 40 mainly includes a main body 41, a head 42 and a clamper 43.

The main body 41 is a portion that constitutes a main structure of the loader 40. The main body 41 is configured to be movable left and right along the rail X (see FIG. 1). In order to stably support the head 42 described later, the main body 41 of the present embodiment is formed so that its front upper portion projects forward. The portion of the main body 41 that projects forward overlaps a back part of the substrate alignment stage 12 in the front-back direction.

The head 42 is a portion where the clamper 43 described later is provided. The head 42 is supported so as to be movable in the front-back direction with respect to the main body 41.

The clamper 43 holds and conveys the substrate 2. The clampers 43 are provided in a number corresponding to the number of the plurality of substrates 2 aligned on the substrate alignment stage 12. In the present embodiment, six clampers 43 are provided on the head 42 so as to correspond to the six substrates 2.

In the case of conveying the substrate 2 of the substrate alignment stage 12 to the resin molding module B by the loader 40, first, the loader 40 moves along the rail X (see FIG. 1), and stops behind the substrate alignment stage 12. Next, as illustrated in FIG. 4, the head 42 moves forward with respect to the main body 41 so that the substrate 2 on the substrate alignment stage 12 and the clamper 43 face each other in the up-down direction. Next, each clamper 43 holds the substrate 2 corresponding thereto, and the head 42 moves backward with respect to the main body 41.

By moving rightward along the rail X (see FIG. 1) while holding the substrate 2, the loader 40 is able to convey the substrate 2 to the resin molding module B. By canceling holding of the substrate 2 on the molding die 16 of the resin molding module B, the loader 40 is able to carry the substrate 2 into the molding die 16.

Although a detailed description is omitted in the present embodiment, the loader 40 carries the resin tablet T to be used for resin molding into the molding die 16 at the same time as carrying in the substrate 2.

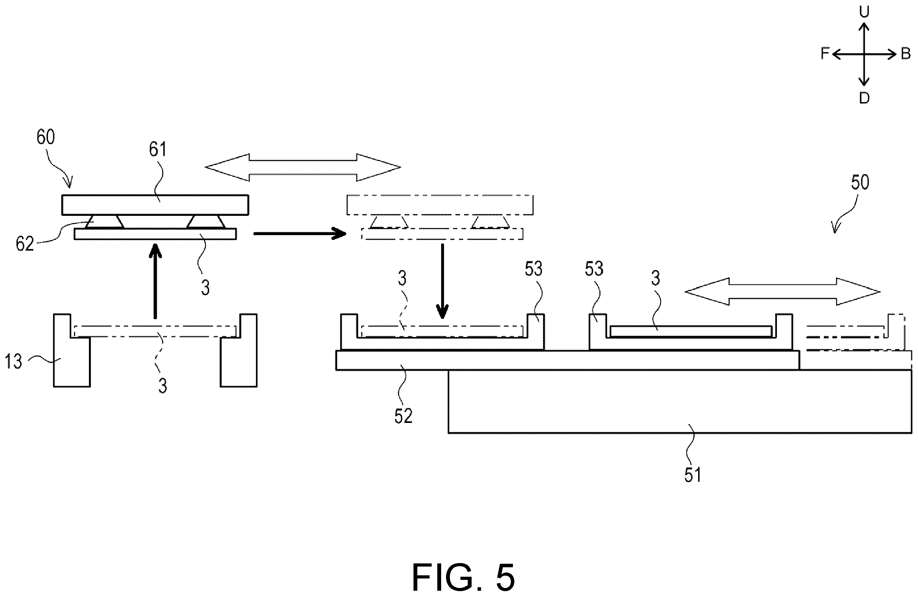

The carrier conveyance unit 50 illustrated in FIG. 1 conveys the carrier 3 arranged on the carrier stage 13 to the carry-out module C. The carrier conveyance unit 50 is an embodiment of a conveyance member conveyance mechanism according to the present invention. The carrier conveyance unit 50 is arranged in the back part of the resin molding apparatus 1. The carrier conveyance unit 50 is movable left and right along the rail X. In the present embodiment, the carrier conveyance unit 50 is configured to move left and right integrally with the loader 40. That is, at least in a movement area along the rail X, the loader 40 and the carrier conveyance unit 50 are movable together. Accordingly, a movement mechanism (not illustrated) for moving the loader 40 and the carrier conveyance unit 50 left and right can be used in common. As illustrated in FIG. 5, the carrier conveyance unit 50 mainly includes a main body 51, a movable stage 52, and a carrier placement part 53.

The main body 51 is a portion that constitutes a main structure of the carrier conveyance unit 50. The main body 51 is configured to be movable left and right along the rail X (see FIG. 1).

The movable stage 52 is a portion where the carrier placement part 53 described later is provided. The movable stage 52 is provided on an upper part of the main body 51. The movable stage 52 is supported so as to be movable in the front-back direction with respect to the main body 51.

The carrier placement part 53 is a portion where the carrier 3 received from the carrier stage 13 is placed. The carrier placement part 53 is provided on an upper part of the movable stage 52. In the present embodiment, two carrier placement parts 53 are arranged side by side in the front-back direction.

The carrier transfer part 60 transfers the carrier 3 from the carrier stage 13 to the carrier conveyance unit 50. As illustrated in FIG. 5, the carrier transfer part 60 mainly includes a head 61 and a suction holding part 62.

The head 61 is a portion where the suction holding part 62 described later is provided. The head 61 is supported so as to be movable by a movement mechanism (not illustrated).

The suction holding part 62 suctions and holds the carrier 3. The suction holding part 62 is provided below the head 61.

In the case of conveying the carrier 3 of the carrier stage 13 to the carry-out module C by the carrier conveyance unit 50, first, the carrier conveyance unit 50 moves along the rail X (see FIG. 1), and stops behind the carrier stage 13. Next, as illustrated in FIG. 5, the carrier 3 of the carrier stage 13 is held by the suction holding part 62 of the carrier transfer part 60 and is placed on the carrier placement part 53 of the carrier conveyance unit 50. At this time, the movable stage 52 moves in the front-back direction as appropriate so that the carrier placement part 53 moves to a position where the carrier 3 can be placed.

By moving rightward along the rail X (see FIG. 1) with the carrier 3 placed on each of the two carrier placement parts 53, the carrier conveyance unit 50 is able to convey the carrier 3 to the carry-out module C. The carrier 3 conveyed to the carry-out module C is accommodated in a carrier accommodation part 80 described later.

The first camera 14 is for reading the code 2a of the substrate 2 and the code 3c of the carrier 3. The first camera 14 is an embodiment of a reading part and a first reading part according to the present invention. The first camera 14 is arranged at a position in the supply module A where it is able to capture an image of the carrier 3 accommodating the substrate 2. In the present embodiment, the first camera 14 is arranged at a position where it is able to capture an image of the carrier 3 arranged in the carrier carry-in part 11.

The control part 15 controls an operation of each module of the resin molding apparatus 1. By the control part 15, operations of the supply module A, the resin molding module B and the carry-out module C are controlled. The operation of each module can be arbitrarily changed (adjusted) using the control part 15. The control part 15 is able to manage information on the substrate 2 and the carrier 3 acquired by the first camera 14 and a second camera 20 described later.

In the present embodiment, an example is illustrated in which the control part 15 is provided in the supply module A. However, it is also possible to provide the control part 15 in any other module. It is also possible to provide a plurality of control parts 15. For example, it is also possible to provide the control part 15 for each module or each device and individually control the operation of each module or the like while causing each module or the like to operate with each other.

### <Resin Molding Module B>

The resin molding module B seals with resin a chip fixed to the substrate 2. In the present embodiment, two resin molding modules B are arranged side by side. By sealing the substrate 2 with resin by the two resin molding modules B in parallel, efficiency of production of resin molded products can be improved. The resin molding module B mainly includes the molding die 16 and a mold clamping mechanism 17.

The molding die 16 seals a chip fixed to the substrate 2 with resin by using a molten resin material. The molding die 16 includes a pair of upper and lower dies, namely a lower die and an upper die. The molding die 16 is provided with a heating part (not illustrated) such as a heater.

The mold clamping mechanism 17 moves the lower die of the molding die 16 up and down, thereby clamping or opening the molding die 16.

### <Carry-out Module C>

The carry-out module C receives and carries out the substrate 2 sealed with resin from the resin molding module B. The carry-out module C mainly includes an unloader 70, a molded substrate alignment stage 18, the carrier accommodation part 80, a carrier carry-out part 19, a molding object accommodation mechanism 90, and the second camera 20.

The unloader 70 holds the substrate 2 sealed with resin in the resin molding module B, and conveys the substrate 2 to the molded substrate alignment stage 18 of the carry-out module C. The unloader 70 is an embodiment of a second molding object conveyance mechanism according to the present invention. The unloader 70 is arranged in the back part of the resin molding apparatus 1. The unloader 70 is movable left and right along the rail X.

The molded substrate alignment stage 18 is a portion where the molded substrate 2 conveyed from the resin molding module B is arranged. The molded substrate alignment stage 18 allows a plurality of substrates 2 to be placed side by side on its upper surface.

In the case of conveying, by the unloader 70, the substrate 2 that has been sealed with resin to the carry-out module C, first, the unloader 70 moves along the rail X to the resin molding module B, and suctions and holds the substrate 2 that has been resin molded by the molding die 16. Next, the unloader 70 moves along the rail X to the carry-out module C, and arranges the molded substrate 2 on the molded substrate alignment stage 18.

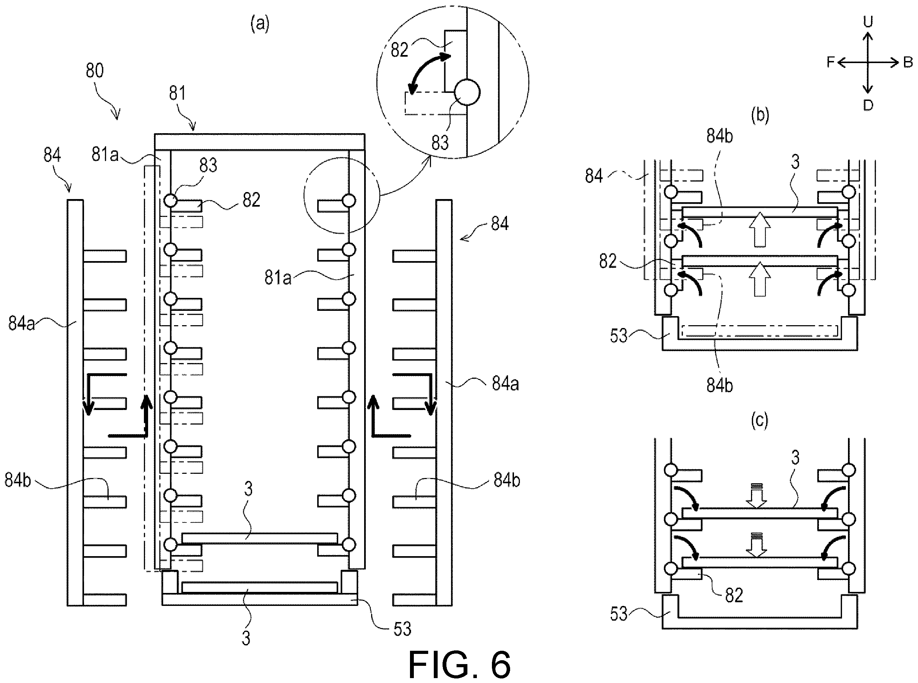

The carrier accommodation part 80 accommodates the carrier 3 from which the substrate 2 has been taken out in the supply module A. The carrier accommodation part 80 is an embodiment of a conveyance member accommodation part according to the present invention. As illustrated in FIG. 6, the carrier accommodation part 80 mainly includes a main body 81, a rotary support 82, a rotary connection part 83, and a lifting part 84.

The main body 81 is a portion that constitutes a main structure of the carrier accommodation part 80. The main body 81 includes a plurality of columns 81a arranged so as to face each other in the front-back direction. Although not illustrated in FIG. 6, a plurality of columns 81a are arranged side by side in a depth direction of the paper. The main body 81 connects upper parts of the columns 81a to each other, thereby being formed into a frame shape with an open bottom.

The rotary support 82 is a portion that supports the carrier 3. The rotary support 82 is provided so as to protrude inward of the main body 81 from the columns 81a in the front-back direction. The rotary support 82 is connected to the column 81a via the rotary connection part 83 described later. A plurality of rotary supports 82 are provided so as to be arranged side by side at equal intervals in the up-down direction. The rotary supports 82 provided on the columns 81a in the front-back direction are arranged at positions (at the same height) corresponding to each other.

The rotary connection part 83 is a portion that connects the rotary support 82 so that the rotary support 82 is rotatable up and down with respect to the column 81a. The rotary connection part 83 supports the rotary support 82 so that the rotary support 82 is freely rotatable from a state of facing in a substantially horizontal direction to a state of facing in a substantially vertical direction. Accordingly, while receiving no external force, the rotary support 82 is rotated downward by its own weight, and faces in the substantially horizontal direction. When an upward external force is applied to the rotary support 82, the rotary support 82 can be rotated upward.

The lifting part 84 is for placing the carrier 3 on the rotary support 82. The lifting part 84 includes columns 84a arranged to face each other in the front-back direction, and a support 84b provided to protrude inward from the columns 84a in the front-back direction. A plurality of supports 84b are provided so as to be arranged side by side at equal intervals in the up-down direction. The interval in the up-down direction between the supports 84b is formed to be the same as the interval in the up-down direction between the rotary supports 82 provided on the main body 81.

By a driving mechanism (not illustrated), the lifting part 84 is movable in the front-back and up-down directions with respect to the main body 81. Specifically, as illustrated in (a) of FIG. 6, in the lifting part 84, a series of operations as follows can be repeated: the support 84b moves horizontally to a position where it protrudes inward of the main body 81, moves upward in that state, moves horizontally outward of the main body 81, and lowers. The lifting part 84 and the main body 81 are arranged so as not to interfere with each other.

By a driving mechanism (not illustrated), the carrier accommodation part 80 as a whole is movable in the front-back and up-down directions. Accordingly, the carrier accommodation part 80 is able to move to a position where it easily accommodates the carrier 3. Specifically, as illustrated in FIG. 6, the carrier accommodation part 80 is able to move to a position facing from above the carrier placement part 53 on which the carrier 3 is placed.

The carrier carry-out part 19 illustrated in FIG. 1 is a portion where the carrier 3 to be carried out from the carry-out module C to the outside is arranged. The carrier carry-out part 19 allows the carrier 3 received from the carrier accommodation part 80 to be placed on its upper surface. By the molding object accommodation mechanism 90 described later, the carrier 3 placed on the carrier carry-out part 19 accommodates the substrate 2 that has been molded. The carrier 3 accommodating the molded substrate 2 is carried out from the carrier carry-out part 19 to the outside.

In the molding object accommodation mechanism 90, the substrate 2 placed on the molded substrate alignment stage 18 is accommodated in the carrier 3 arranged in the carrier carry-out part 19. As the molding object accommodation mechanism 90, for example, like the take-out mechanism 30 (see FIG. 3), a mechanism capable of holding and conveying the substrate 2 can be used. A detailed description of the configuration of the molding object accommodation mechanism 90 will be omitted.

The second camera 20 is for reading the code 2a of the molded substrate 2 and the code 3c of the carrier 3. The second camera 20 is an embodiment of a reading part and a second reading part according to the present invention. The second camera 20 is arranged at a position in the carry-out module C where it is able to capture an image of the molded substrate 2 and the carrier 3 in which the molded substrate 2 is accommodated. In the present embodiment, the second camera 20 is arranged at a position where it is able to capture an image of the carrier 3 arranged in the carrier carry-out part 19.

### <Overview of Operation of Resin Molding Apparatus 1>

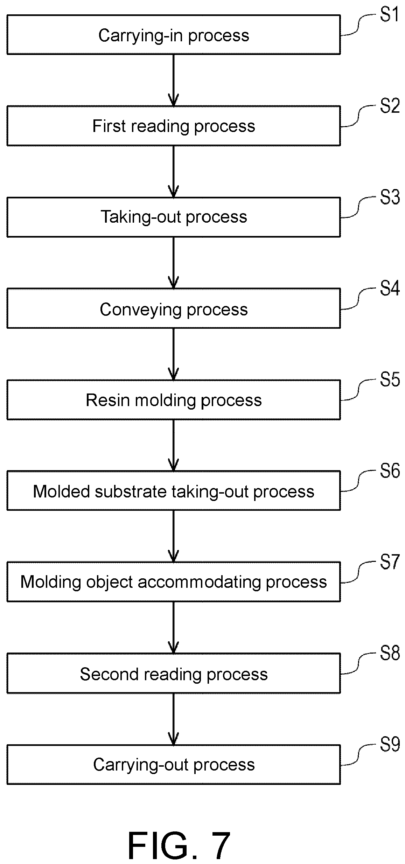

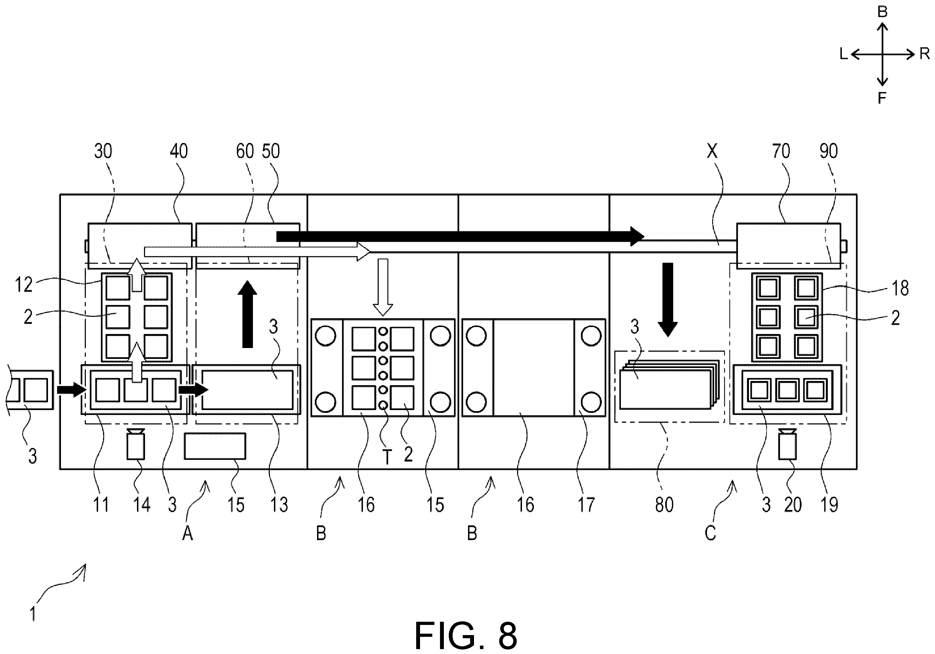

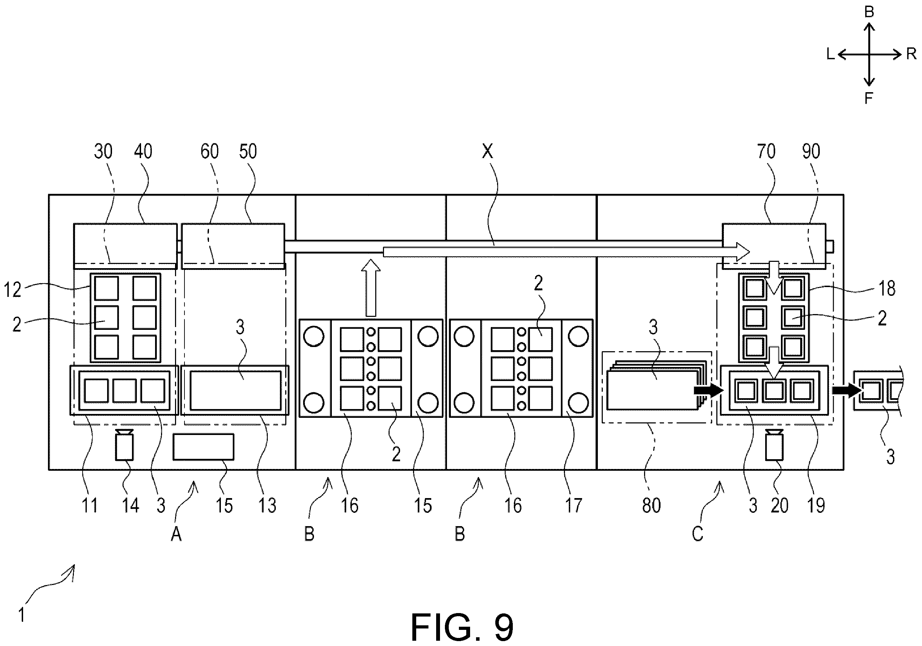

In the following, an overview of an operation (method for producing a resin molded product using the resin molding apparatus 1) of the resin molding apparatus 1 configured as above will be described with reference to FIG. 7 to FIG. 9. The black arrows illustrated in FIG. 8 and FIG. 9 indicate a manner in which the carrier 3 moves. The white arrows indicate a manner in which the substrate 2 moves.

As illustrated in FIG. 7, a method for producing a resin molded product according to the present embodiment mainly includes: a carrying-in process S1, a first reading process S2, a taking-out process S3, a conveying process S4, a resin molding process S5, a molded substrate taking-out process S6, a molding object accommodating process S7, a second reading process S8, and a carrying-out process S9. For ease of description, FIG. 7 describes the processes in order one at a time. However, in reality, the operations in different processes may be executed at the same time, or a specific process may be repeated multiple times.

First, the carrying-in process S1 is executed. The carrying-in process S1 is a process in which the carrier 3 is carried from the outside into the resin molding apparatus 1. In the carrying-in process S1, the carrier 3 accommodating the substrate 2 is carried into the carrier carry-in part 11 of the supply module A (see FIG. 8).

Next, the first reading process S2 is executed. The first reading process S2 is a process in which the code 3c of the carrier 3 and the code 2a of the substrate 2 accommodated in the carrier 3 are read. In the first reading process S2, the first camera 14 captures an image of the carrier 3 and the substrate 2 carried into the carrier carry-in part 11. The control part 15 reads the code 3c of the carrier 3 and the code 2a of the substrate 2 from the image captured by the first camera 14, and identifies the carrier 3 and the substrate 2. The control part 15 stores a correspondence between the carrier 3 and the substrate 2 accommodated in the carrier 3 in association with each other. That is, the control part 15 stores which substrate 2 is accommodated in the carrier 3.

Next, the taking-out process S3 is executed. The taking-out process S3 is a process in which the substrate 2 is taken out from the carrier 3. In the taking-out process S3, the take-out mechanism 30 takes out the substrate 2 from the carrier 3 of the carrier carry-in part 11 and arranges the substrates 2 side by side on the substrate alignment stage 12 (see FIG. 8). In the present embodiment, since six substrates 2 can be arranged on the substrate alignment stage 12, a total of six substrates 2 are taken out from two carriers 3 to the substrate alignment stage 12.

Here, an order of arrangement of the substrate 2 on the substrate alignment stage 12 in the taking-out process S3 is described. As illustrated in FIG. 4, the main body 41 of the loader 40 is formed so as to project forward. Hence, in a state in which the loader 40 is located behind the substrate alignment stage 12, the take-out mechanism 30 and the loader 40 may interfere with each other, making it unlikely to arrange the substrate 2 at a position (back part) on the substrate alignment stage 12 close to the loader 40. For example, in the present embodiment, as illustrated in FIG. 4, since the substrate 2 in the backmost row of the three rows in the front-back direction is arranged at a position overlapping the main body 41 of the loader 40, when the substrate 2 is arranged in the backmost row (positions (1) and (2) in (b) of FIG. 10), there is a risk of interference between the take-out mechanism 30 and the loader 40.

In the present embodiment, an example is described in which the positions where the main body 41 of the loader 40 and the substrate 2 are arranged overlap. However, even if the positions where the loader 40 and the substrate 2 are arranged do not overlap, it is assumed that the take-out mechanism 30 and the loader 40 may interfere with each other.

Accordingly, in the taking-out process S3, when the substrate 2 is taken out from the first carrier 3, as illustrated in (a) of FIG. 10, the loader 40 is retreated to a retreat position shifted from behind to the right of the substrate alignment stage 12. In this state, the take-out mechanism 30 does not interfere with the loader 40. In this state, the take-out mechanism 30 takes out the substrate 2 to the substrate alignment stage 12.

At this time, the take-out mechanism 30 arranges the substrates 2 in an order from a side (back side) close to the loader 40. For example, in the present embodiment, as illustrated in (b) of FIG. 10, an arrangement order of (1) to (6) is set in order from the back side of the substrate alignment stage 12. That is, the three substrates 2 taken out from the first carrier 3 are arranged at positions (1) to (3). Accordingly, the substrate 2 can be arranged at the positions (1) and (2) where there is a risk of interference between the take-out mechanism 30 and the loader 40.

When the loader 40 is retreated to the position shifted to the right from the substrate alignment stage 12, the loader 40 receives the resin tablet T from the resin supply device (not illustrated). In this way, by utilizing the time of retreating as the time for receiving the resin tablet T, production efficiency can be improved.

When the three substrates 2 from the first carrier 3 are taken out to the substrate alignment stage 12, the loader 40 and the carrier conveyance unit 50 integrally move leftward. Accordingly, the loader 40 moves to a position (behind the substrate alignment stage 12) where the loader 40 is able to receive the substrate 2 of the substrate alignment stage 12, and the carrier conveyance unit 50 moves to a position (behind the carrier stage 13) where the carrier conveyance unit 50 is able to receive the carrier 3 of the carrier stage 13.

The first carrier 3 from which the substrates 2 have been taken out is moved from the carrier carry-in part 11 to the carrier stage 13 by an appropriate movement mechanism.

After the first carrier 3 moves from the carrier carry-in part 11 to the carrier stage 13, the carrying-in process S1, the first reading process S2, and the taking-out process S3 are executed again. Accordingly, the substrates 2 accommodated in the second carrier 3 are taken out to the substrate alignment stage 12, and six substrates 2 are aligned on the substrate alignment stage 12.

At this time, since the loader 40 is located behind the substrate alignment stage 12, the backmost row (positions (1) and (2) in (b) of FIG. 10) on the substrate alignment stage 12 overlaps the main body 41 of the loader 40, and in this row, the substrates 2 taken out from the first carrier 3 have already been arranged. That is, since the substrates 2 taken out from the second carrier 3 are not arranged in the backmost row on the substrate alignment stage 12, there is no risk of interference between the take-out mechanism 30 and the loader 40.

Next, the conveying process S4 is executed. The conveying process S4 is a process in which the substrate 2 is conveyed to the molding die 16 and the carrier 3 is conveyed to the carrier accommodation part 80. The conveying process S4 is an embodiment of a molding object conveying process and a conveyance member conveying process according to the present invention. In the conveying process S4, the loader 40 holds the six substrates 2 aligned on the substrate alignment stage 12 (see FIG. 4). By the carrier transfer part 60, the carrier 3 of the carrier stage 13 is transferred to carrier placement part 53 of the carrier conveyance unit 50 (see FIG. 5). At this time, two carriers 3 are placed on two carrier placement parts 53, respectively.

Next, as illustrated in FIG. 8, the loader 40 and the carrier conveyance unit 50 integrally move rightward. In the resin molding module B, the loader 40 delivers the substrate 2 and the resin tablet T to the molding die 16. After that, the loader 40 and the carrier conveyance unit 50 further move rightward. In the carry-out module C, the carrier accommodation part 80 receives the carrier 3 from the carrier conveyance unit 50.

Here, a manner in which the carrier accommodation part 80 receives the carrier 3 in the conveying process S4 is described with reference to FIG. 6. In the case where the carrier accommodation part 80 receives the carrier 3, first, as illustrated in (a) of FIG. 6, the carrier accommodation part 80 moves to above the carrier placement part 53.

Next, as illustrated in (b) of FIG. 6, the lifting part 84 moves to the inside the main body 81 and then moves upward. Accordingly, the support 84b provided at the bottom lifts up the carrier 3 of the carrier placement part 53 from below. By the carrier 3 lifted up, the rotary support 82 is pushed up from below, and the rotary support 82 is rotated upward.

When the carrier 3 is lifted up above the rotary support 82, the rotary support 82 returns to a substantially horizontal position due to its own weight, as illustrated in (c) of FIG. 6. In this state, the carrier 3 is placed on the rotary support 82, and the lifting part 84 is retreated to the outside of the main body 81. In this way, the carrier 3 of the carrier placement part 53 is supported by the rotary support 82 provided at the bottom of the carrier accommodation part 80.

At this time, the carrier 3 that has already been accommodated in the carrier accommodation part 80 is also lifted up to one stage (rotary support 82 directly above) directly above by another support 84b of the lifting part 84. That is, the carrier 3 conveyed to the carry-out module C is accommodated in the bottom stage of the carrier accommodation part 80, and moves up one stage each time another carrier 3 is conveyed.

In this way, a plurality of carriers 3 conveyed to the carry-out module C are arranged side by side and accommodated in order from an upper stage of the carrier accommodation part 80 based on the order in which the carriers 3 were conveyed. In this way, by providing the resin molding apparatus 1 with the carrier accommodation part 80 and securing an accommodation place for a plurality of carriers 3, the substrate 2 (carrier 3) can be smoothly carried into the resin molding apparatus 1. Thus, the occurrence of waiting time can be prevented and the efficiency of production of resin molded products can be improved. Since the carriers 3 are arranged side by side and accommodated from the top in the order in which they were conveyed, an operator is able to easily and intuitively grasp the order of conveyance of the carriers 3 and efficiently perform confirmation or the like on the carrier 3.

The above-mentioned processes from the carrying-in process S 1 to the conveying process S4 are repeated according to the number of resin molding modules B. For example, in the present embodiment, since two resin molding modules B are provided, the processes are repeated until the substrate 2 is conveyed to the molding die 16 of the two resin molding modules B.

Next, the resin molding process S5 is executed. The resin molding process S5 is a process in which the substrate 2 conveyed to the molding die 16 is resin molded. In the resin molding process S5, the mold clamping mechanism 17 lifts the lower die and clamps the molding die 16. The resin tablet T is heated and melted by the heating part (not illustrated) of the molding die 16, and molten resin generated is used to seal the substrate 2 with resin.

Next, the molded substrate taking-out process S6 is executed. The molded substrate taking-out process S6 is a process in which the substrate 2 resin molded by the molding die 16 is taken out of the molding die 16. In the molded substrate taking-out process S6, the unloader 70 holds the substrate 2 that has been resin molded by the molding die 16, moves the substrate 2 along the rail X to the carry-out module C, and arranges the molded substrate 2 on the molded substrate alignment stage 18 (see FIG. 9).

If a plurality of resin molding modules B (molding dies 16) are provided as in the present embodiment, the unloader 70 carries out the molded substrates 2 in order from the molding die 16 to which the substrate 2 was previously conveyed in the conveying process S4. Accordingly, a correspondence between the substrate 2 and the carrier 3 in the molding object accommodating process S7 described later can be maintained.

Next, the molding object accommodating process S7 is executed. The molding object accommodating process S7 is a process in which the molded substrate 2 is accommodated in the carrier 3. In the molding object accommodating process S7, first, the carrier 3 accommodated in the carrier accommodation part 80 is taken out to the carrier carry-out part 19 by an appropriate movement mechanism. At this time, among the carriers 3 accommodated in the carrier accommodation part 80, the carriers 3 accommodated in the top stage are taken out. Next, by the molding object accommodation mechanism 90, the substrate 2 placed on the molded substrate alignment stage 18 is accommodated in the carrier 3 arranged in the carrier carry-out part 19.

Next, the second reading process S8 is executed. The second reading process S8 is a process in which the code 3c of the carrier 3 and the code 2a of the molded substrate 2 accommodated in the carrier 3 are read. In the second reading process S8, the second camera 20 captures an image of the carrier 3 accommodating the molded substrate 2. The control part 15 reads the code 3c of the carrier 3 and the code 2a of the molded substrate 2 from the image captured by the second camera 20, and identifies the carrier 3 and the substrate 2. The control part 15 determines whether a correspondence between the carrier 3 and the molded substrate 2 coincides with the correspondence stored in the first reading process S2. If the correspondence between the carrier 3 and the substrate 2 does not coincide with the correspondence stored in the first reading process S2, the control part 15 may, for example, issue a warning to the operator or stop the operation of the resin molding apparatus 1.

Next, the carrying-out process S9 is executed. The carrying-out process S9 is a process in which the carrier 3 is carried out from the resin molding apparatus 1 to the outside. In the carrying-out process S9, the carrier 3 accommodating the molded substrate 2 is carried out from the carrier carry-out part 19 of the carry-out module C to the outside (see FIG. 9).

As described above, in the resin molding apparatus 1 according to the present embodiment, the substrate 2 accommodated in the carrier 3 can be taken out from the carrier 3 and subjected to resin molding. Accordingly, an increase in size of the molding die 16 can be prevented. Since the substrate 2 can be directly positioned with respect to the molding die 16, the positional accuracy of the substrate 2 can be improved.

In the resin molding apparatus 1 according to the present embodiment, the substrate 2 after resin molding can be accommodated in the carrier 3 again. At this time, the substrate 2 is accommodated in the same carrier 3 that accommodated the substrate 2 before resin molding. Accordingly, for example, management (such as lot management) of the substrate 2 can be performed using the carrier 3.

The above has described an embodiment of the present invention. However, the present invention is not limited to the above embodiment, and appropriate changes can be made within the scope of the technical idea of the invention described in the claims.

For example, the configuration (such as shape or number) of each member described in each of the above embodiments is not particularly limited and can be arbitrarily changed. As an example, a method for holding the substrate 2 by the loader 40 or the unloader 70 is not particularly limited. A method for holding the carrier 3 by the carrier conveyance unit 50 is not particularly limited. The number of substrates 2 and carriers 3 conveyed by each device at one time, the arrangement or the like of the substrates 2 on the substrate alignment stage 12 and in the molding die 16 can be arbitrarily changed.

In the present embodiment, an example is illustrated in which a code such as a two-dimensional code is assigned to each of the substrate 2 and the carrier 3. However, the present invention is not limited thereto. It is possible to use various other identifiers. For example, it is possible to use a character string or a color as an identifier, or to use, as an identifier, an IC tag that can withstand an environment (such as heat or load) in the resin molding apparatus 1. In the case of using an IC tag, identifier information can be read using, instead of the first camera 14 or the like, a communication device capable of communicating with the IC tag.

The reading process (first reading process S2 and second reading process S8) illustrated in the present embodiment is an example. The code 2a of the substrate 2 and the code 3c of the carrier 3 can be read in any place and at any timing. As an example, in the present embodiment, it is illustrated that the code 3c of the carrier 3 taken out from the carrier accommodation part 80 is read by the second camera 20 (see the second reading process S8). However, it is also possible to read the code 3c of the carrier 3 accommodated in the carrier accommodation part 80 in the conveying process S4. Accordingly, the carrier 3 accommodated in the carrier accommodation part 80 can be identified, and whether the carrier 3 is accommodated in a suitable position or the like can be grasped.

In addition, it is also possible to read, using the second camera 20, the code 2a of the molded substrate 2 (substrate 2 placed on molded substrate alignment stage 18) before the molded substrate 2 is accommodated in the carrier 3. It is also possible to read, using the first camera 14, the code 2a of the substrate 2 arranged on the substrate alignment stage 12 or the code 3c of the carrier 3 arranged on the carrier stage 13.

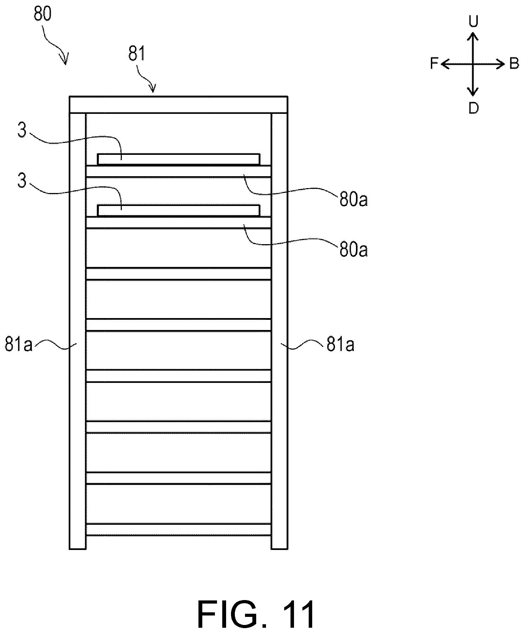

The carrier accommodation part 80 (see FIG. 6) illustrated in the present embodiment is an example, and the specific configuration of the carrier accommodation part 80 can be arbitrarily changed. For example, like a modification of the carrier accommodation part 80 as illustrated in FIG. 11, it is also possible to accommodate the carrier 3 in a non-rotatable multistage support 80a instead of the rotary support 82 that is rotatable. In this case, for example, the carrier accommodation part 80 can be lifted and lowered in the up-down direction as appropriate according to a height of the carrier 3 being conveyed, and the carrier 3 can be accommodated in each support 80a from the side. In this case as well, it is desirable that the carriers 3 be accommodated in order from an upper stage (or lower stage) of the carrier accommodation part 80 based on the order in which the carriers 3 were conveyed.

In the present embodiment, an example is illustrated in which three substrates 2 are accommodated in one carrier 3 and six substrates 2 (substrates 2 carried in by two carriers 3) are molded by one molding die 16. However, this is an example. The number of substrates 2 that can be accommodated in the carrier 3 and the number of substrates 2 that can be molded at the same time by one molding die 16 can be arbitrarily changed. For example, while one carrier 3 is able to accommodate three substrates 2, it is possible that the number of substrates 2 that can be molded by one molding die 16 is eight, ten, twelve and so on. Even if the relationship between the number of substrates 2 that can be accommodated in the carrier 3 and the number of substrates 2 that can be molded by the molding die 16 is changed in this way, by the resin molding apparatus 1 according to the present embodiment, the correspondence between the substrate 2 and the carrier 3 before and after molding can be maintained. That is, in the resin molding apparatus 1, since the carrier 3 from which the substrate 2 has been taken out is accommodated in order in the carrier accommodation part 80, and the molded substrate 2 is accommodated in order in the carrier 3, the correspondence between the substrate 2 and the carrier 3 is maintained. Furthermore, in the resin molding apparatus 1, since the correspondence between the substrate 2 and the carrier 3 can be confirmed by the first camera 14 and the second camera 20, the correspondence between the substrate 2 and the carrier 3 can be relatively reliably maintained.

The operation of the resin molding apparatus 1 illustrated in the present embodiment is an example, and the present invention is not limited thereto. That is, the order or manner of operation of each part of the resin molding apparatus 1 can be arbitrarily changed.

### <Additional Remark>

The resin molding apparatus 1 of a first aspect of the present disclosure includes: the take-out mechanism 30, taking out the substrate 2 (molding object) from the carrier 3 (conveyance member) accommodating the substrate 2; the loader 40 (first molding object conveyance mechanism), conveying the substrate 2 taken out from the carrier 3 to the molding die 16; the carrier accommodation part 80 (conveyance member accommodation part), capable of accommodating the carrier 3 from which the substrate 2 has been taken out; the carrier conveyance unit 50 (conveyance member conveyance mechanism), conveying, to the carrier accommodation part 80, the carrier 3 from which the substrate 2 has been taken out; the mold clamping mechanism 17, clamping the molding die 16 to which the substrate 2 is conveyed, so as to perform resin molding; the unloader 70 (second molding object conveyance mechanism), carrying the substrate 2 after molding out of the molding die 16; and a molding object accommodation mechanism, causing the carrier 3 accommodated in the carrier accommodation part 80 to accommodate the substrate 2 carried out of the molding die 16.

According to the resin molding apparatus 1 of the first aspect of the present disclosure, the substrate 2 accommodated in the carrier 3 can be taken out and subjected to resin molding, and then the substrate 2 can be accommodated in the carrier 3 again. Accordingly, an increase in size of the molding die 16 can be prevented. Since the substrate 2 can be positioned directly with respect to the molding die 16, the positional accuracy of the substrate 2 can be improved.

In the resin molding apparatus 1 of a second aspect according to the first aspect, the loader 40 and the carrier conveyance unit 50 are movable together in at least a portion of a movement area.

According to the resin molding apparatus 1 of the second aspect of the present disclosure, since the loader 40 and the carrier conveyance unit 50 share the movement area, an increase in size of the resin molding apparatus 1 can be prevented.

The resin molding apparatus 1 of a third aspect according to the first or second aspect includes: a reading part (first camera 14, second camera 20), capable of reading an identifier (code 3c, code 2a) assigned to at least one of the carrier 3 and the substrate 2.

According to the resin molding apparatus 1 of the third aspect of the present disclosure, at least one of the carrier 3 and the substrate 2 can be identified and managed. Accordingly, it is easy to confirm whether the substrate 2 or the carrier 3 is conveyed or molded or the like without any problems.

The resin molding apparatus 1 of a fourth aspect according to the first or second aspect includes: the first camera 14 (first reading part), capable of reading an identifier assigned to the substrate 2 before molding and the carrier 3 in which the substrate 2 before molding is accommodated; and the second camera 20 (second reading part), capable of reading an identifier assigned to the substrate 2 after molding and the carrier 3 in which the substrate 2 after molding is accommodated.

According to the resin molding apparatus 1 of the fourth aspect of the present disclosure, a correspondence between the substrate 2 before or after molding and the carrier 3 can be confirmed. Accordingly, since it is easy to maintain the correspondence between the substrate 2 before or after molding and the carrier 3, management (such as lot management) of the substrate 2 using the carrier 3, for example, is facilitated.

In the resin molding apparatus 1 of a fifth aspect according to any one of the first to fourth aspects, the carrier accommodation part 80 is able to accommodate a plurality of the carriers 3 based on the order in which the carriers 3 are conveyed by the carrier conveyance unit 50. According to the resin molding apparatus 1 of the fifth aspect of the present disclosure, since the carriers 3 can be accommodated in the order in which they were conveyed, it is easy to manage or grasp the order of the carriers 3.

The resin molding apparatus 1 of a sixth aspect according to any one of the first to fifth aspects includes: the substrate alignment stage 12 (placement part), on which the substrate 2 taken out by the take-out mechanism 30 is placed. The take-out mechanism 30 places the substrate 2 taken out from the carrier 3 on the substrate alignment stage 12 so as not to interfere with the loader 40.

According to the resin molding apparatus 1 of the fifth aspect of the present disclosure, interference with the loader 40 when the substrate 2 is taken out can be prevented.

In the resin molding apparatus 1 of a seventh aspect according to the sixth aspect, the take-out mechanism 30 places the substrate 2 at a predetermined position on the substrate alignment stage 12 while the loader 40 is retreated to a retreat position.

According to the resin molding apparatus 1 of the seventh aspect of the present disclosure, interference with the loader 40 when the substrate 2 is taken out can be prevented.

A method for producing a resin molded product according to an eighth aspect of the present disclosure is a method for producing a resin molded product using the resin molding apparatus according to any one of the first to seventh aspects. The method includes: the taking-out process S3 in which the substrate 2 is taken out from the carrier 3; the conveying process S4 (molding object conveying process) in which the substrate 2 taken out by the taking-out process S3 is conveyed to the molding die 16; the conveying process S4 (conveyance member conveying process) in which the carrier 3 from which the substrate 2 has been taken out is conveyed; the resin molding process S5 in which the substrate 2 conveyed to the molding die 16 by the conveying process S4 is resin molded; and the molding object accommodating process S7 in which the substrate 2 resin molded by the resin molding process S5 is accommodated in the carrier 3 conveyed by the conveying process S4.

According to the method for producing a resin molded product of the eighth aspect of the present disclosure, the substrate 2 accommodated in the carrier 3 can be taken out and subjected to resin molding. Accordingly, an increase in size of the molding die 16 can be prevented. Since the substrate 2 can be positioned directly with respect to the molding die 16, the positional accuracy of the substrate 2 can be improved.

### Description of Reference Numerals

1: resin molding apparatus
2: substrate
3: carrier
12: substrate alignment stage
14: first camera
16: molding die
17: mold clamping mechanism
20: second camera
30: take-out mechanism
40: loader
50: carrier conveyance unit
70: unloader
80: carrier accommodation part

## Claims

1. A resin molding apparatus, comprising:
a take-out mechanism, taking out a molding object from a conveyance member accommodating the molding object;
a first molding object conveyance mechanism, conveying the molding object taken out from the conveyance member to a molding die;
a conveyance member accommodation part, capable of accommodating the conveyance member from which the molding object has been taken out;
a conveyance member conveyance mechanism, conveying, to the conveyance member accommodation part, the conveyance member from which the molding object has been taken out;
a mold clamping mechanism, clamping the molding die to which the molding object is conveyed, so as to perform resin molding;
a second molding object conveyance mechanism, carrying the molding object after molding out of the molding die; and
a molding object accommodation mechanism, causing the conveyance member accommodated in the conveyance member accommodation part to accommodate the molding object carried out of the molding die.

2. The resin molding apparatus according to claim 1, wherein
the first molding object conveyance mechanism and the conveyance member conveyance mechanism are movable together in at least a portion of a movement area.

3. The resin molding apparatus according to claim 1 or 2, comprising:
a reading part, capable of reading an identifier assigned to at least one of the conveyance member and the molding object.

4. The resin molding apparatus according to claim 1 or 2, comprising:
a first reading part, capable of reading an identifier assigned to the molding object before molding and the conveyance member in which the molding object before molding is accommodated; and
a second reading part, capable of reading an identifier assigned to the molding object after molding and the conveyance member in which the molding object after molding is accommodated.

5. The resin molding apparatus according to any one of claims 1 to 4, wherein
the conveyance member accommodation part is capable of accommodating a plurality of the conveyance members based on an order in which the conveyance members are conveyed by the conveyance member conveyance mechanism.

6. The resin molding apparatus according to any one of claims 1 to 5, comprising:
a placement part, on which the molding object taken out by the take-out mechanism is placed, wherein
the take-out mechanism places the molding object taken out from the conveyance member on the placement part so as not to interfere with the first molding object conveyance mechanism.

7. The resin molding apparatus according to claim 6, wherein
the take-out mechanism places the molding object at a predetermined position on the placement part while the first molding object conveyance mechanism is retreated to a retreat position.

8. A method for producing a resin molded product using the resin molding apparatus according to any one of claims 1 to 7, the method comprising:
taking out the molding object from the conveyance member;
conveying the molding object taken out in the taking out the molding object to the molding die;
conveying the conveyance member from which the molding object has been taken out;
resin molding the molding object conveyed to the molding die in the conveying the molding object; and
accommodating the molding object resin molded in the resin molding the molding object in the conveyance member conveyed in the conveying the conveyance member.
